# EUROPÄISCHE PATENTSCHRIFT

(11) **EP 3 169 213 B1**
(45) Veröffentlichungstag und Bekanntmachung des Hinweises auf die Patenterteilung: **15.08.2018**
(21) Anmeldenummer: 15733710.6
(22) Anmeldetag: 30.06.2015
(51) Int. Cl.: A47L 15/00, H05K 9/00, H01H 13/702

(54) **ELEKTRONISCHE BENUTZERSCHNITTSTELLE MIT EINER ABSCHIRMVORRICHTUNG**
ELECTRONIC USER INTERFACE COMPRISING A SHIELDING DEVICE
INTERFACE UTILISATEUR ÉLECTRONIQUE POURVUE D'UN DISPOSITIF DE PROTECTION

(30) Priorität: 17.07.2014 DE 102014213903
(43) Veröffentlichungstag der Anmeldung: 24.05.2017
(73) Patentinhaber: BSH Hausgeräte GmbH, 81739 München (DE)
(72) Erfinder: ADAM, Paul, 93161 Sinzing / Viehhausen (DE); BICHLER, Markus, 83132 Pittenhart (DE); MAKHTYUK, Roman, 93087 Alteglofsheim (DE); SORG, Matthias, 83379 Wonneberg (DE)
(86) Internationale Anmeldenummer: PCT/EP2015/064882
(87) Internationale Veröffentlichungsnummer: WO 2016/008723

(56) Entgegenhaltungen:
- WO-A1-2009/090016
- DE-A1- 4 221 115
- DE-A1- 19 714 195
- DE-A1-102008 031 433
- DE-U1- 29 520 531
- US-A- 5 652 410

## Beschreibung

Die Erfindung betrifft eine elektronische Benutzerschnittstelle, aufweisend eine Gerätefrontblende mit einer Innenseite, wenigstens ein an der Gerätefrontblende angeordnetes Ein- und/oder Ausgabemittel, sowie wenigstens ein Blendenteil, das eine elektrisch leitende Oberfläche aufweist.

Die DE 295 20 531 U1 beschreibt ein Haushaltsgerät mit einem Bedienpult, welches einen an der Gerätevorderseite angeordneten Blendenträger und einen am Blendenträger angekoppelten und ein elektrisch leitfähiges Material, insbesondere Metall, aufweisenden Blendeneinleger umfasst. Der dortige Blendeneinleger ist mittels eines elektrisch leitenden Andruckelementes mit einer Geräte-Schutzerdung verbunden. Das Dokument DE 10 2008 031433 A1 betrifft eine Betätigungsvorrichtung zur Steuerung einer Sanitärarmatur z.B. für eine Dusche, einen Wasserhahn oder eine Toilettenspülung oder dgl., mit einem druckempfindlichen Tastenfeld zur Erfassung von Steuerbefehlen , wobei die Betätigungsvorrichtung eine Frontblende mit Tastenfelder aufweist, die eine Abdeckung aufweisen. Die Abdeckung umfasst eine elektrisch leitende transparente Beschichtung, die mit dem Gehäuse ausgeführt aus elektrisch leitendem Metall verbunden ist, so dass sich dadurch ein faradayischer Käfig ergibt, der die darin untergebrachten elektronischen Bauteilen elektromagnetisch abschirmt.

Das Dokument DE 197 14 195 A1 betrifft eine Bedienvorrichtung zum Einstellen des Betriebszustandes eines Haushaltsgerätes, die ein platten-förmiges Bedienelement umfasst. Eine Teiloberfläche der Vorderseite des Bedienelements ist als Berührfläche vorgesehen, die eine bedienende Person durch Berühren bedienen kann, um einen Betriebszustand des Haushaltsgerätes einzustellen. In einer Ausführungsform besteht die Berührfläche aus Metall, so dass die hinter der Berührfläche angeordneten Elektroniken gegen elektrostatische Entladungen vom Finger der bedienenden Person abgeschirmt werden und die Elektromagnetische Verträglichkeit (EMV) der Bedienvorrichtung erhöht wird.

Die Aufgabe der Erfindung ist es, eine elektronische Benutzerschnittstelle, insbesondere eine elektronische Benutzerschnittstelle eines Haushaltsgeräts zu schaffen, bei der eine hinter einer Gerätefrontblende angeordnete elektronische Baugruppe gegen elektrische und/oder magnetische Felder auch dann geschützt ist, wenn ein elektrisch leitendes Blendenteil der Gerätefrontblende ohne Schutzerdung ausgeführt ist.

Die Aufgabe der Erfindung wird gelöst durch eine elektronische Benutzerschnittstelle, aufweisend eine Gerätefrontblende mit einer Innenseite, wenigstens ein an der Gerätefrontblende angeordnetes Ein- und/oder Ausgabemittel, sowie wenigstens ein Blendenteil, das eine elektrisch leitende Oberfläche aufweist und ohne Schutzerdung ausgeführt ist, des Weiteren aufweisend
eine hinter der Innenseite der Gerätefrontblende angeordnete elektronische Baugruppe und eine die elektronische Baugruppe von dem wenigstens einen elektrisch leitenden Blendenteil gegen elektrische und/oder magnetische Felder abschirmende Abschirmvorrichtung.

Das wenigstens eine Ein- und/oder Ausgabemittel kann insbesondere ein elektrischer Schalter oder Taster, ein Drehsteller, ein elektronisches Display, ein elektrisches Leuchtmittel und/oder eine Touch-Folie sein.

Indem die elektronische Benutzerschnittstelle eine hinter der Innenseite der Gerätefrontblende angeordnete elektronische Baugruppe und eine die elektronische Baugruppe von dem wenigstens einen elektrisch leitenden Blendenteil gegen elektrische und/oder magnetische Felder abschirmende Abschirmvorrichtung aufweist, kann die elektronische Baugruppe mittels der Abschirmvorrichtung vor Beschädigungen bzw. Zerstörung geschützt werden, die beispielsweise durch eine unbeabsichtigte elektrostatische Entladung auftreten könnten.

Insbesondere Haushaltsgeräte weisen im Allgemeinen mehrere Bedientasten und wenigstens ein Anzeigemittel auf. Die Bedientasten und das wenigstens eine Anzeigemittel können in einer Frontblende des Haushaltsgeräts untergebracht sein. Im Inneren des Haushaltsgeräts sind dann, mit Ausnahme der sichtbaren Teile der Bedientasten und Anzeigemittel selbst, optisch hinter der Frontblende verborgen, die übrigen Komponenten einer die Bedientasten und Anzeigemittel umfassenden elektronischen Benutzerschnittstelle angeordnet.

Die elektronische Benutzerschnittstelle kann demgemäß eine Leiterplatte aufweisen, welche in einem beispielsweise in das Haushaltsgerät eingebautem Zustand mit einer nicht näher dargestellten Steuervorrichtung des Haushaltsgeräts elektrisch verbunden ist. Auf der Leiterplatte können ein oder mehrere Bedientasten und Anzeigemittel elektrisch kontaktiert angeordnet sein. Das wenigstens eine Ein- und/oder Ausgabemittel kann wenigstens ein elektronisches Display umfassen. Das wenigstens eine elektronische Display kann auch als ein Touch-Display ausgebildet sein, welches insoweit dann die Bedientasten mit aufweist. Das wenigstens eine elektronische Display kann insbesondere ein TFT-Display, oder ganz allgemein beispielsweise ein LCD-Bildschirm oder ein LED-Display sein. Generell kann es sich auch um ein Touchscreen handeln. Das elektronische Display kann die erfindungsgemäße elektronische Baugruppe bilden bzw. enthalten.

Die Abschirmvorrichtung kann ein Blech oder eine Metallfolie, insbesondere ein Blech oder eine Metallfolie aus ferromagnetischem Material sein. Die Abschirmvorrichtung ist weder selbst unmittelbar mit einer Schutzerdung versehen, noch ist die Abschirmvorrichtung über die elektronische Baugruppe oder in einer anderen Weise indirekt über die elektronische Baugruppe mit einer Schutzerdung versehen.

Die Abschirmvorrichtung kann zwischen der Innenseite der Gerätefrontblende und der elektronischen Baugruppe angeordnet sein.

Die Abschirmvorrichtung kann sich im Wesentlichen lediglich in einer Ebene zwischen der Innenseite der Gerätefrontblende und der elektronischen Baugruppe erstrecken, insbesondere kann dabei die Abschirmvorrichtung eine umlaufende Außenkante aufweisen, welche im Wesentlichen in der Ebene liegt, in der die Abschirmvorrichtung sich zwischen der Innenseite der Gerätefrontblende und der elektronischen Baugruppe erstreckt.

Die umlaufende Außenkante kann zumindest annähernd die Grundform eines Rechteckes oder Quadrates aufweisen. Neben ein oder mehreren randoffenen Aussparungen und/oder Löchern kann die Abschirmvorrichtung eine große zentrale Öffnung aufweisen. Die zentrale Öffnung kann insbesondere eine Kreisöffnung sein. Die Abschirmvorrichtung weist in einem solchen Fall einen die zentrale Öffnung, insbesondere die Kreisöffnung umgebenden Abschirmkörper auf, der trotz ein oder mehreren randoffenen Aussparungen und/oder Löchern, eine geschlossene, elektrisch leitende Ringstruktur bildet.

Die Abschirmvorrichtung kann weniger als zwei Millimeter, insbesondere weniger als ein Millimeter von einer Rückseite des elektrisch leitenden Blendenteils entfernt angeordnet sein.

Die Abschirmvorrichtung bzw. der Abschirmkörper kann an jeder seiner Ecken jeweils einen Haken aufweisen. Die Haken können dann sowohl der mechanischen Fixierung der Abschirmvorrichtung bzw. des Abschirmkörpers an der Gerätefrontblende, als auch einer elektrische leitenden Verbindung der Abschirmvorrichtung bzw. des Abschirmkörpers mit dem elektrisch leitenden Blendenteil, insbesondere dem Blendenteil dienen. Die Abschirmvorrichtung bzw. der Abschirmkörper ist beide frei von einer Schutzerdung.

Die Abschirmvorrichtung und/oder das wenigstens eine elektrisch leitende Blendenteil kann generell frei von einer Schutzerdung sein. Die elektronische Benutzerschnittstelle kann insbesondere mehrere Blendenteile aufweisen, die jeweils eine elektrisch leitende Oberfläche aufweisen. Ein spezielles Blendenteil kann einen Blendenring darstellen, welcher eine elektrisch leitende Ringoberfläche aufweist und Teil eines manuellen Drehstellers ist. Der manuelle Drehsteller kann wiederum eines von dem wenigstens einen Ein- und/oder Ausgabemittel bilden.

Der elektrisch leitende Blendenring kann ein frontseitiges Betätigungsbauteil bilden, mit dem ein Benutzer das Ein- und/oder Ausgabemittel manuell betätigen, insbesondere ansteuern kann. Der Blendenring kann eine elektrisch leitende Oberfläche aufweisen. Alternativ kann der Blendenring aus einem elektrisch leitenden Material hergestellt sein, insbesondere vollständig aus einem elektrisch leitenden Material bestehen. Der Blendenring und die weiteren jeweils elektrisch leitenden Blendenteile sind elektrisch isoliert in der Gerätefrontblende aus elektrisch nichtleitendem Kunststoff gelagert und sind ohne eine Schutzerdung ausgeführt. Mit dem Blendenring kann das Ein- und/oder Ausgabemittel einen Betätigungsabschnitt, insbesondere einen kreisförmigen oder ringförmigen Betätigungsabschnitt aufweisen, wobei der Betätigungsabschnitt das elektrisch leitende Blendenteil, insbesondere den Blendenring lediglich aufweist oder der Betätigungsabschnitt das elektrisch leitende Blendenteil, insbesondere den Blendenring sogar selbst ist.

Die Abschirmvorrichtung kann eine zentrale Öffnung, insbesondere eine Kreisöffnung aufweisen und einen die zentrale Öffnung, insbesondere die Kreisöffnung umgebenden Abschirmkörper aufweisen, der eine geschlossene, elektrisch leitende Ringstruktur bildet.

Das Ein- und/oder Ausgabemittel weist erfindungsgemäß einen Betätigungsabschnitt, insbesondere einen kreisförmigen oder ringförmigen Betätigungsabschnitt auf und der Betätigungsabschnitt weist dabei das elektrisch leitende Blendenteil auf oder der Betätigungsabschnitt ist dabei das elektrisch leitende Blendenteil. Die Abschirmvorrichtung kann eine zentrale Öffnung, insbesondere eine Kreisöffnung aufweisen und das Ein- und/oder Ausgabemittel, insbesondere der kreisförmige oder ringförmige Betätigungsabschnitt, welcher das elektrisch leitende Blendenteil aufweist, kann dabei zumindest im Wesentlichen koaxial zum Zentrum der zentralen Öffnung, insbesondere zum Mittelpunkt der Kreisöffnung angeordnet sein.

Die Erfindung betrifft demgemäß auch ein Haushaltsgerät, insbesondere ein Kältegerät, einen Herd, ein Kochfeld, eine Dunstabzugshaube, eine Geschirrspülmaschine, eine Waschmaschine, einen Wäschetrockner oder einen Kaffeevollautomaten, das eine erfindungsgemäße elektronische Benutzerschnittstelle, wie beschrieben, aufweist.

Zwei konkrete Ausführungsbeispiele erfindungsgemäßer elektronischer Benutzerschnittstellen sind in der nachfolgenden Beschreibung unter Bezugnahme auf die beigefügten Figuren näher erläutert. Konkrete Merkmale dieser Ausführungsbeispiele können unabhängig davon, in welchem Zusammenhang sie erwähnt sind, gegebenenfalls auch einzeln oder in Kombination betrachtet, allgemeine Merkmale der Erfindung darstellen.

Es zeigen:
- Fig. 1: eine perspektivische schematische Darstellung eines beispielhaften Haushaltsgeräts in Art einer Waschmaschine mit einer erfindungsgemäßen elektronischen Benutzerschnittstelle,
- Fig. 2: eine Explosionsdarstellung in Rückansicht einer beispielhaften ersten Ausführungsform einer elektronischen Benutzerschnittstelle mit einer erfindungsgemäßen Abschirmvorrichtung,
- Fig. 3: eine perspektivische Darstellung in Rückansicht der elektronischen Benutzerschnittstelle gemäß Fig. 2 in einer zusammengebauten Alleinstellung,
- Fig. 4: eine perspektivische Darstellung einer alternativen Ausführungsform einer Abschirmvorrichtung in Alleinstellung; und
- Fig. 5: eine perspektivische Darstellung in Rückansicht einer beispielhaften zweiten Ausführungsform einer elektronischen Benutzerschnittstelle mit der alternativen Abschirmvorrichtung gemäß Fig. 4 in einer zusammengebauten Alleinstellung.

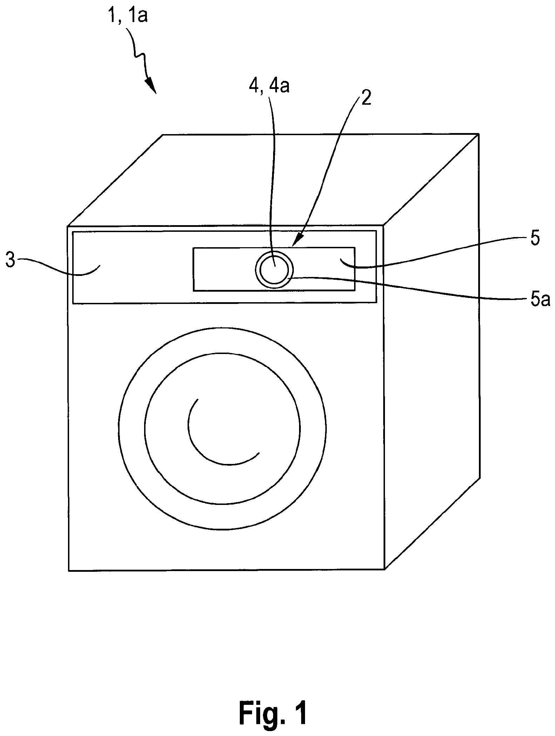

Ein in Fig. 1 beispielhaft dargestelltes Haushaltsgerät 1 ist als eine Waschmaschine 1a ausgebildet. Die Waschmaschine 1a weist eine elektronische Benutzerschnittstelle 2 auf.

Die elektronische Benutzerschnittstelle 2 umfasst eine Gerätefrontblende 3. An der Gerätefrontblende 3 ist wenigstens ein Ein- und/oder Ausgabemittel 4 angeordnet. Die elektronische Benutzerschnittstelle 2 weist im Falle des vorliegenden Ausführungsbeispiels mehrere Blendenteile 5 auf, die jeweils eine elektrisch leitende Oberfläche aufweisen. Ein spezielles Blendenteil stellt einen Blendenring 5a dar, welcher eine elektrisch leitende Ringoberfläche aufweist und Teil eines manuellen Drehstellers 4a ist. Der manuelle Drehsteller 4a wiederum bildet eines von dem wenigstens einen Ein- und/oder Ausgabemittel 4.

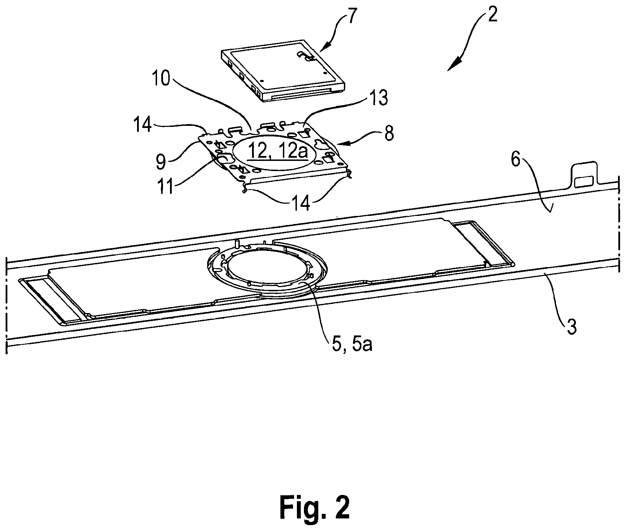

In der Fig. 2 sind Einzelteile dieser elektronischen Benutzerschnittstelle 2 dargestellt. Die Gerätefrontblende 3 wird im Falle des vorliegenden Ausführungsbeispiels von einem elektrisch nichtleitenden Spritzguss-Kunststoffteil gebildet, welches eine Innenseite 6 aufweist. An einer von der Innenseite 6 abgewandten Frontseite des Spritzguss-Kunststoffteils weist die Gerätefrontblende 3 einen elektrisch leitenden Blendenring 5a des Ein- und/oder Ausgabemittels 4 auf, welcher drehbar gelagert ist. Der elektrisch leitende Blendenring 5a bildet ein frontseitiges Betätigungsbauteil, mit dem ein Benutzer das Ein- und/oder Ausgabemittel 4 manuell betätigen, insbesondere ansteuern kann. Der Blendenring 5a kann eine elektrisch leitende Oberfläche aufweisen. Alternativ kann der Blendenring 5a aus einem elektrisch leitenden Material hergestellt sein, insbesondere vollständig aus einem elektrisch leitenden Material bestehen. Der Blendenring 5a und die weiteren jeweils elektrisch leitenden Blendenteile 5 sind elektrisch isoliert in der Gerätefrontblende 3 aus elektrisch nichtleitendem Kunststoff gelagert und ohne eine Schutzerdung ausgeführt. Mit dem Blendenring 5a weist das Ein- und/oder Ausgabemittel 4 einen Betätigungsabschnitt, insbesondere einen kreisförmigen oder ringförmigen Betätigungsabschnitt auf, wobei der Betätigungsabschnitt das elektrisch leitende Blendenteil 5, insbesondere den Blendenring 5a lediglich aufweist oder der Betätigungsabschnitt das elektrisch leitende Blendenteil 5, insbesondere den Blendenring 5a sogar selbst ist.

Hinter der Innenseite 6 der Gerätefrontblende 3 ist eine elektronische Baugruppe 7 angeordnet. Die elektronische Baugruppe 7 kann beispielsweise eine Steuerplatine sein, durch welche das wenigstens eine Ein- und/oder Ausgabemittel 4 angesteuert wird. Die elektronische Baugruppe 7 kann aber auch ein Anzeigemittel aufweisen, das beispielsweise ein elektronisches Display, insbesondere in der Bauart eines TFT-Displays sein kann. Die elektronische Baugruppe 7 ist in einem in das Haushaltsgerät 1 eingebautem Zustand mit einer nicht näher dargestellten Steuervorrichtung des Haushaltsgeräts 1, bzw. der Waschmaschine 1a elektrisch verbunden.

Erfindungsgemäß ist eine die elektronische Baugruppe 7 von dem wenigstens einen elektrisch leitenden Blendenteil 5, insbesondere von dem elektrisch leitenden Blendenring 5a gegen elektrische und/oder magnetische Felder abschirmende Abschirmvorrichtung 8 an der elektronischen Benutzerschnittstelle 2 vorgesehen.

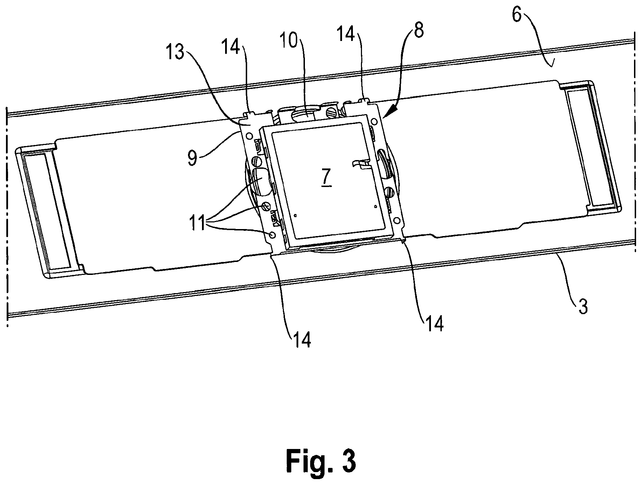

Die Abschirmvorrichtung 8 ist im Falle des vorliegenden ersten Ausführungsbeispiels der Fig. 2 und Fig. 3 ein Blech aus ferromagnetischem Material. Die Abschirmvorrichtung 8 ist weder selbst unmittelbar mit einer Schutzerdung versehen, noch ist die Abschirmvorrichtung 8 über die elektronische Baugruppe 7 oder in einer anderen Weise indirekt über die elektronische Baugruppe 7 mit einer Schutzerdung versehen.

Die Abschirmvorrichtung 8 erstreckt sich im Wesentlichen lediglich in einer Ebene zwischen der Innenseite 6 der Gerätefrontblende 3 und der elektronischen Baugruppe 7. Dabei weist die Abschirmvorrichtung 8 eine umlaufende Außenkante 9 auf, welche im Wesentlichen in der Ebene liegt, in der die Abschirmvorrichtung 8 sich zwischen der Innenseite 6 der Gerätefrontblende 3 und der elektronischen Baugruppe 7 erstreckt. Die umlaufende Außenkante 9 weist zumindest annähernd die Grundform eines Rechteckes oder Quadrates auf. Neben ein oder mehreren randoffenen Aussparungen 10 und/oder Löchern 11 weist die Abschirmvorrichtung 8 eine große zentrale Öffnung 12 auf. Die zentrale Öffnung 12 ist im Falle des vorliegenden ersten Ausführungsbeispiels eine Kreisöffnung 12a. Die Abschirmvorrichtung 8 weist dadurch einen die zentrale Öffnung 12, insbesondere die Kreisöffnung 12a umgebenden Abschirmkörper 13 auf, der trotz ein oder mehreren randoffenen Aussparungen 10 und/oder Löchern 11, eine geschlossene, elektrisch leitende Ringstruktur bildet.

Die Abschirmvorrichtung 8 bzw. der Abschirmkörper 13, der die zentrale Öffnung 12, insbesondere die Kreisöffnung 12a aufweist und das Ein- und/oder Ausgabemittel 4, insbesondere der kreisförmige oder ringförmige Betätigungsabschnitt, welcher das elektrisch leitende Blendenteil 5 bzw. den elektrisch leitenden Blendenring 5a aufweist, ist zumindest im Wesentlichen koaxial zum Zentrum der zentralen Öffnung 12, insbesondere zum Mittelpunkt der Kreisöffnung 12a angeordnet.

Die Abschirmvorrichtung 8 bzw. der Abschirmkörper 13 weist an jeder seiner Ecken jeweils einen Haken 14 auf. Die Haken 14 dienen sowohl der mechanischen Fixierung der Abschirmvorrichtung 8 bzw. des Abschirmkörpers 13 an der Gerätefrontblende 3, als auch einer elektrische leitenden Verbindung der Abschirmvorrichtung 8 bzw. des Abschirmkörpers 13 mit dem elektrisch leitenden Blendenteil, insbesondere dem Blendenteil 5. Die Abschirmvorrichtung 8 bzw. der Abschirmkörper 13 ist frei von einer Schutzerdung.

In einer Einbaulage gemäß Fig. 3 ist die Abschirmvorrichtung 8 bzw. der Abschirmkörper 13 weniger als zwei Millimeter, insbesondere weniger als ein Millimeter von einer Rückseite des elektrisch leitenden Blendenteils 5, insbesondere des elektrisch leitenden Blendenrings 5a entfernt angeordnet.

Die Abschirmvorrichtung 8 bzw. der Abschirmkörper 13 ist dabei zwischen der Innenseite 6 der Gerätefrontblende 3 und der elektronischen Baugruppe 7 angeordnet.

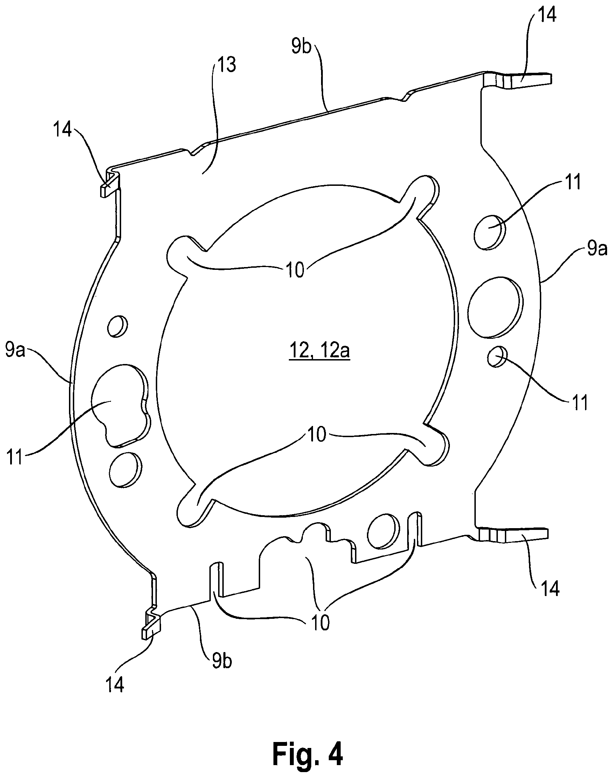

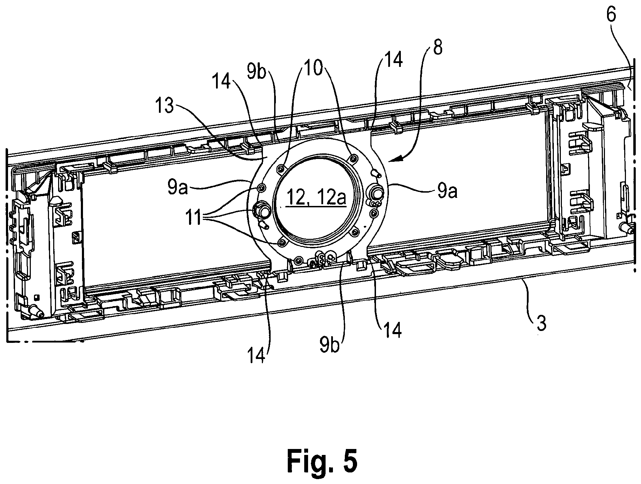

Im Falle des zweiten Ausführungsbeispiels der Fig. 4 und Fig. 5 ist die Abschirmvorrichtung 8 bzw. der Abschirmkörper 13 auch ein Blech aus ferromagnetischem Material. Die Abschirmvorrichtung 8 ist ebenso wie im Falle des ersten Ausführungsbeispiels weder selbst unmittelbar mit einer Schutzerdung versehen, noch ist die Abschirmvorrichtung 8 über die elektronischen Baugruppe 7 oder in einer anderen Weise indirekt über die elektronische Baugruppe 7 mit einer Schutzerdung versehen.

Auch im Falle des zweiten Ausführungsbeispiels ist die Abschirmvorrichtung 8 zwischen der Innenseite 6 der Gerätefrontblende 3 und der elektronischen Baugruppe 7 angeordnet.

Die Abschirmvorrichtung 8 des zweiten Ausführungsbeispiels erstreckt sich im Wesentlichen lediglich in einer Ebene zwischen der Innenseite 6 der Gerätefrontblende 3 und der elektronischen Baugruppe 7. Dabei weist die Abschirmvorrichtung 8 eine umlaufende Außenkante 9 auf, welche im Wesentlichen in der Ebene liegt, in der die Abschirmvorrichtung 8 sich zwischen der Innenseite 6 der Gerätefrontblende 3 und der elektronischen Baugruppe 7 erstreckt. Die umlaufende Außenkante 9 weist zwei gegenüberliegende kreisbogenförmige Abschnitte 9a und zwei gegenüberliegende gerade Abschnitte 9b auf. Neben ein oder mehreren randoffenen Aussparungen 10 und/oder Löchern 11 weist die Abschirmvorrichtung 8 eine große zentrale Öffnung 12 auf. Die zentrale Öffnung 12 ist im Falle des vorliegenden zweiten Ausführungsbeispiels auch eine Kreisöffnung 12a. Die Abschirmvorrichtung 8 weist dadurch einen die zentrale Öffnung 12, insbesondere die Kreisöffnung 12a umgebenden Abschirmkörper 13 auf, der trotz ein oder mehreren randoffenen Aussparungen 10 und/oder Löchern 11, eine geschlossene, elektrisch leitende Ringstruktur bildet.

Die Abschirmvorrichtung 8 bzw. der Abschirmkörper 13, der die zentrale Öffnung 12, insbesondere die Kreisöffnung 12a aufweist und das Ein- und/oder Ausgabemittel 4, insbesondere der kreisförmige oder ringförmige Betätigungsabschnitt, welcher das elektrisch leitende Blendenteil 5 bzw. den elektrisch leitenden Blendenring 5a aufweist, ist auch hier zumindest im Wesentlichen koaxial zum Zentrum der zentralen Öffnung 12, insbesondere zum Mittelpunkt der Kreisöffnung 12a angeordnet.

Die Abschirmvorrichtung 8 bzw. der Abschirmkörper 13 weist an jeder seiner Ecken jeweils einen Haken 14 auf. Die Haken 14 dienen sowohl der mechanischen Fixierung der Abschirmvorrichtung 8 bzw. des Abschirmkörpers 13 an der Gerätefrontblende 3, als auch einer elektrische leitenden Verbindung der Abschirmvorrichtung 8 bzw. des Abschirmkörpers 13 mit dem elektrisch leitenden Blendenteil, insbesondere dem Blendenteil 5. Die Abschirmvorrichtung 8 bzw. der Abschirmkörper 13 ist jedoch auch hierbei frei von einer Schutzerdung.

In einer Einbaulage gemäß Fig. 5 ist die Abschirmvorrichtung 8 bzw. der Abschirmkörper 13 weniger als zwei Millimeter, insbesondere weniger als ein Millimeter von einer Rückseite des elektrisch leitenden Blendenteils 5, insbesondere des elektrisch leitenden Blendenrings 5a entfernt angeordnet. Die Abschirmvorrichtung 8 bzw. der Abschirmkörper 13 ist dabei zwischen der Innenseite 6 der Gerätefrontblende 3 und der elektronischen Baugruppe 7 angeordnet.

### BEZUGSZEICHENLISTE

- 1: Haushaltsgerät
- 1a: Waschmaschine
- 2: elektronische Benutzerschnittstelle
- 3: Gerätefrontblende
- 4: Ein- und/oder Ausgabemittel
- 4a: Drehsteller
- 5: Blendenteil
- 5a: Blendenring
- 6: Innenseite
- 7: elektronische Baugruppe
- 8: Abschirmvorrichtung
- 9: Außenkante
- 9a: kreisbogenförmiger Abschnitt
- 9b: gerader Abschnitt
- 10: Aussparung
- 11: Löcher
- 12: zentrale Öffnung
- 12a: Kreisöffnung
- 13: Abschirmkörper
- 14: Haken

## Patentansprüche

1. Elektronische Benutzerschnittstelle, aufweisend eine Gerätefrontblende (3) mit einer Innenseite (6), wenigstens ein an der Gerätefrontblende (3) angeordnetes Ein- und/oder Ausgabemittel (4), sowie wenigstens ein Blendenteil (5), das eine elektrisch leitende Oberfläche aufweist und ohne Schutzerdung ausgeführt ist, **gekennzeichnet durch** eine hinter der Innenseite (6) der Gerätefrontblende (3) angeordnete elektronische Baugruppe (7) und eine die elektronische Baugruppe (7) von dem wenigstens einen elektrisch leitenden Blendenteil (5) gegen elektrische und/oder magnetische Felder abschirmende Abschirmvorrichtung (8), wobei das Ein- und/oder Ausgabemittel (4) einen Betätigungsabschnitt aufweist und der Betätigungsabschnitt das elektrisch leitende Blendenteil (5) aufweist oder der Betätigungsabschnitt das elektrisch leitende Blendenteil (5) ist.

2. Elektronische Benutzerschnittstelle nach Anspruch 1, **dadurch gekennzeichnet, dass** die Abschirmvorrichtung (8) ein Blech oder eine Metallfolie, insbesondere ein Blech oder eine Metallfolie aus ferromagnetischem Material ist.

3. Elektronische Benutzerschnittstelle nach Anspruch 1 oder 2, **dadurch gekennzeichnet, dass** die Abschirmvorrichtung (8) zwischen der Innenseite (6) der Gerätefrontblende (3) und der elektronischen Baugruppe (7) angeordnet ist.

4. Elektronische Benutzerschnittstelle nach einem der Ansprüche 1 bis 3, **dadurch gekennzeichnet, dass** die Abschirmvorrichtung (8) sich im Wesentlichen lediglich in einer Ebene zwischen der Innenseite (6) der Gerätefrontblende (3) und der elektronischen Baugruppe (7) erstreckt, insbesondere die Abschirmvorrichtung (8) eine umlaufende Außenkante (9) aufweist, welche im Wesentlichen in der Ebene liegt, in der die Abschirmvorrichtung (8) sich zwischen der Innenseite (6) der Gerätefrontblende (3) und der elektronischen Baugruppe (7) erstreckt.

5. Elektronische Benutzerschnittstelle nach einem der Ansprüche 1 bis 4, **dadurch gekennzeichnet, dass** die Abschirmvorrichtung (8) weniger als zwei Millimeter, insbesondere weniger als ein Millimeter von einer Rückseite des elektrisch leitenden Blendenteils (5) entfernt angeordnet ist.

6. Elektronische Benutzerschnittstelle nach einem der Ansprüche 1 bis 5, **dadurch gekennzeichnet, dass** die Abschirmvorrichtung (8) und/oder das wenigstens eine elektrisch leitende Blendenteil (5) frei von einer Schutzerdung ist.

7. Elektronische Benutzerschnittstelle nach einem der Ansprüche 1 bis 6, **dadurch gekennzeichnet, dass** die Abschirmvorrichtung (8) eine zentrale Öffnung (12), insbesondere eine Kreisöffnung (12a) und einen die zentrale Öffnung (12), insbesondere die Kreisöffnung (12a) umgebenden Abschirmkörper (13) aufweist, der eine geschlossene, elektrisch leitende Ringstruktur bildet.

8. Elektronische Benutzerschnittstelle nach einem der Ansprüche 1 bis 7, **dadurch gekennzeichnet, dass** das der Betätigungsabschnitt einen kreisförmigen oder ringförmigen Betätigungsabschnitt aufweist.

9. Elektronische Benutzerschnittstelle nach Anspruch 8, **dadurch gekennzeichnet, dass** die Abschirmvorrichtung (8) eine zentrale Öffnung (12), insbesondere eine Kreisöffnung (12a) aufweist und das Ein- und/oder Ausgabemittel (4), insbesondere der kreisförmige oder ringförmige Betätigungsabschnitt, welcher das elektrisch leitende Blendenteil (5) aufweist, zumindest im Wesentlichen koaxial zum Zentrum der zentralen Öffnung (12), insbesondere zum Mittelpunkt der Kreisöffnung (12a) angeordnet ist.

10. Haushaltsgerät, aufweisend eine elektronische Benutzerschnittstelle (2) nach einem der Ansprüche 1 bis 9.

## Claims

1. Electronic user interface, having an appliance front panel (3) with an inner face (6), at least one input and/or output means (4) arranged on the appliance front panel (3) and at least one panel part (5) which has an electrically conducting surface and is designed without protective earthing, **characterised by** an electronic module (7) arranged behind the inner side (6) of the appliance front panel (3) and a shielding apparatus (8) shielding the electronic module (7) of the at least one electrically conducting panel part (5) from electrical and/or magnetic fields, wherein the input and/or output means (4) has an actuating section and the actuating section has the electrically conducting panel part (5) or the actuating section is the electrically conducting panel part (5).

2. Electronic user interface according to claim 1, **characterised in that** the shielding apparatus (8) is a metal sheet or a metal film, in particular a metal sheet or a metal film made from ferromagnetic material.

3. Electronic user interface according to claim 1 or 2, **characterised in that** the shielding apparatus (8) is arranged between the inner side (6) of the appliance front panel (3) and the electronic module (7).

4. Electronic user interface according to one of claims 1 to 3, **characterised in that** the shielding apparatus (8) extends substantially only in a plane between the inner side (6) of the appliance front panel (3) and the electronic module (7), in particular the shielding apparatus (8) has a peripheral outer edge (9), which lies substantially in the plane in which the shielding apparatus (8) extends between the inner side (6) of the appliance front panel (3) and the electronic module (7).

5. Electronic unit interface according to one of claims 1 to 4, **characterised in that** the shielding apparatus (8) is arranged at a distance of less than two millimetres, in particular less than one millimetre from a rear side of the electrically conducting panel part (5).

6. Electronic user interface according to one of claims 1 to 5, **characterised in that** the shielding apparatus (8) and/or the at least one electrically conducting panel part (5) is free of a protective earthing.

7. Electronic user interface according to one of claims 1 to 6, **characterised in that** the shielding apparatus (8) has a central opening (12), in particular a circular opening (12a) and a shielding body (13) surrounding the central opening (12), in particular the circular opening (12a), said shielding body forming a closed, electrically conducting annular structure.

8. Electronic user interface according to one of claims 1 to 7, **characterised in that** the actuating section has a circular or ring-shaped actuating section.

9. Electronic user interface according to claim 8, **characterised in that** the shielding apparatus (8) has a central opening (12), in particular a circular opening (12a) and the input and/or output means (4), in particular the circular or ring-shaped actuating section which has the electrically conducting panel part (5), is arranged at least substantially coaxially with respect to the centre of the central opening (12), in particular with respect to the centre point of the circular opening (12a).

10. Domestic appliance, having an electronic user interface (2) according to one of claims 1 to 9.

## Revendications

1. Interface utilisateur électronique présentant un panneau frontal d'appareil (3) muni d'une face intérieure (6), au moins un moyen d'entrée et/ou de sortie (4) disposé sur le panneau frontal d'appareil (3), ainsi qu'au moins une pièce de parement (5) qui présente une surface électro-conductrice et est réalisée sans prise de terre, **caractérisée par** un ensemble électronique (7) disposé derrière la face intérieure (6) du panneau frontal d'appareil (3) et par un dispositif de blindage (8) protégeant l'ensemble électronique (7) de l'au moins une pièce de parement (5) électro-conductrice contre les champs électriques et/ou magnétiques, le moyen d'entrée et/ou de sortie (4) présentant une section de commande, et la section de commande présentant la pièce de parement (5) électro-conductrice ou la section de commande étant la pièce de parement (5) électro-conductrice.

2. Interface utilisateur électronique selon la revendication 1, **caractérisée en ce que** le dispositif de blindage (8) est une tôle ou une feuille métallique, notamment une tôle ou une feuille métallique en matière ferromagnétique.

3. Interface utilisateur électronique selon la revendication 1 ou 2, **caractérisée en ce que** le dispositif de blindage (8) est disposé entre la face intérieure (6) du panneau frontal d'appareil (3) et l'ensemble électronique (7).

4. Interface utilisateur électronique selon l'une quelconque des revendications 1 à 3, **caractérisée en ce que** le dispositif de blindage (8) s'étend essentiellement uniquement dans un plan situé entre la face intérieure (6) du panneau frontal d'appareil (3) et l'ensemble électronique (7), notamment **en ce que** le dispositif de blindage (8) présente une arête extérieure (9) périphérique, laquelle est essentiellement située dans le plan dans lequel le dispositif de blindage (8) s'étend entre la face intérieure (6) du panneau frontal d'appareil (3) et l'ensemble électronique (7).

5. Interface utilisateur électronique selon l'une quelconque des revendications 1 à 4, **caractérisée en ce que** le dispositif de blindage (8) est disposé de manière distancée de moins deux millimètres, notamment de moins d'un millimètre, d'un côté arrière de la pièce de parement (5) électro-conductrice.

6. Interface utilisateur électronique selon l'une quelconque des revendications 1 à 5, **caractérisée en ce que** le dispositif de blindage (8) et/ou l'au moins une pièce de parement (5) électro-conductrice sont exempts d'une prise de terre.

7. Interface utilisateur électronique selon l'une quelconque des revendications 1 à 6, **caractérisée en ce que** le dispositif de blindage (8) présente une ouverture centrale (12), notamment une ouverture circulaire (12a), et un corps de blindage (13) entourant l'ouverture centrale (12), notamment l'ouverture circulaire (12a), lequel forme une structure annulaire fermée électro-conductrice.

8. Interface utilisateur électronique selon l'une quelconque des revendications 1 à 7, **caractérisée en ce que** la section de commande présente une section de commande circulaire ou annulaire.

9. Interface utilisateur électronique selon la revendication 8, **caractérisée en ce que** le dispositif de blindage (8) présente une ouverture centrale (12), notamment une ouverture circulaire (12a), et **en ce que** le moyen d'entrée et/ou de sortie (4), notamment la section de commande circulaire ou annulaire, laquelle présente la pièce de parement (5) électro-conductrice, est disposé au moins essentiellement coaxialement par rapport au centre de l'ouverture centrale (12), notamment par rapport au centre de l'ouverture circulaire (12a).

10. Appareil ménager présentant une interface utilisateur électronique (2) selon l'une quelconque des revendications 1 à 9.
